# FASCICULE DE BREVET EUROPEEN

(11) **EP 2 176 445 B1**
(45) Date de publication et mention de la délivrance du brevet: **01.12.2010**
(21) Numéro de dépôt: 08775285.3
(22) Date de dépôt: 22.07.2008
(51) Int. Cl.: C23C 16/458, C23C 16/04

(54) **PROCEDE ET DISPOSITIF D'INFILTRATION D'UNE STRUCTURE EN MATERIAU POREUX PAR DEPOT CHIMIQUE EN PHASE VAPEUR**
VERFAHREN UND VORRICHTUNG ZUR INFILTRATION EINER STRUKTUR EINES PORÖSEN MATERIALS DURCH CHEMISCHE GASPHASENABSCHEIDUNG
METHOD AND DEVICE FOR THE INFILTRATION OF A STRUCTURE OF A POROUS MATERIAL BY CHEMICAL VAPOUR DEPOSITION

(30) Priorité: 25.07.2007 FR 0756728
(43) Date de publication de la demande: 21.04.2010
(73) Titulaire: Commissariat à l'Énergie Atomique et aux Énergies Alternatives, 75015 Paris (FR)
(72) Inventeur: DONET, Sébastien, F-38112 Meaudre (FR); EMIEUX, Fabrice, F-38340 Voreppe (FR); FILHOL, Lionel, F-38160 Saint Sauveur (FR); THOLLON, Stéphanie, 33770 Salles (FR)
(74) Mandataire: Ilgart, Jean-Christophe
(86) Numéro de dépôt international: PCT/EP2008/059613
(87) Numéro de publication internationale: WO 2009/013296

(56) Documents cités:
- EP-A- 1 199 109
- EP-A- 1 285 976
- WO-A-96/15285
- WO-A-96/15288
- WO-A-96/33295
- SEMYANNIKOV P P ET AL: "Chemical vapor infiltration method for deposition of gold nanoparticles on porous alumina supports" JOURNAL OF STRUCTURAL CHEMISTRY, KLUWER ACADEMIC PUBLISHERS-PLENUM PUBLISHERS, NE, vol. 47, no. 3, 1 mai 2006 (2006-05-01), pages 458-464, XP019451837 ISSN: 1573-8779

## Description

### DOMAINE TECHNIQUE

La présente invention concerne un procédé et un dispositif d'infiltration d'une structure en matériau poreux par dépôt chimique en phase vapeur (CVD), pour obtenir notamment des multicouches ou des hétérostructures pour des systèmes catalytiques (« Washcoat » + métal).

### ÉTAT DE LA TECHNIQUE ANTÉRIEURE

Des systèmes catalytiques de type « wash coat » + métal se présentent sous la forme de films minces continus et homogènes et/ou de particules de taille nanométrique (de 1 à 100 nm de diamètre) bien dispersées en surface d'une structure dense ou poreuse. Leurs domaines d'application concernent, par exemple, la catalyse de l'air (traitement des polluants : composés organiques volatils (COV), oxydes d'azote (NOx)), la génération d'hydrogène par reformage d'hydrocarbures, ou de biocarburants ou le stockage d'hydrogène par adsorption.

La technique de réalisation classique de tels catalyseurs est l'imprégnation en voie liquide, par exemple par dépôt de particules d'argent comme décrit dans le document référencé [1] en fin de description ou par dépôt de particules de platine comme décrit dans le document référencé [2]. Les inconvénients principaux de cette technique sont les suivants :
- Elle nécessite une quantité de matière déposée importante : de 5 à 10 fois plus que par dépôt CVD.
- Elle induit une inhomogénéité de dépôt due à l'écoulement de liquide au sein des structures poreuses.
- Elle doit être suivie d'une étape de traitement thermique (séchage et calcination).

Le dépôt CVD est en général utilisé pour recouvrir des surfaces lisses. Pour des structures en matériau poreux, on préfère un dépôt en phase liquide de façon à pénétrer au mieux ces structures. Mais un tel dépôt en phase liquide est difficilement contrôlable et l'épaisseur de dépôt est grande. Il n'est donc pas question de l'utiliser pour infiltrer des matériaux à pores très petits.

La présente invention a pour objet un procédé et un dispositif d'infiltration d'une structure en matériau poreux par dépôt chimique en phase vapeur permettant de résoudre les problèmes techniques existant dans les solutions de l'art antérieur, comme défini ci-dessus.

### EXPOSÉ DE L'INVENTION

L'invention concerne un procédé d'infiltration d'une structure en matériau poreux par dépôt chimique en phase vapeur comprenant deux faces opposées, la première face étant exposée à un flux gazeux, la seconde face étant, au moins en partie, libre de tout contact, **caractérisé en ce que** l'on interpose un support percé de canaux parallèles et muni d'un cône de forçage entre le flux gazeux et la structure en matériau poreux, cette structure étant posée sur, ou suspendue au dessus de ce support.

Avantageusement, le support est un support cylindrique en inconel.

Avantageusement, on peut également basculer d'un angle α la structure en matériau poreux par rapport à la normale du support, α étant compris entre 1 et 15°.

Le procédé de l'invention comprend les étapes suivantes :
- une première étape de synthèse de particules ou de film d'oxydes,
- une seconde étape de dispersion d'au moins un métal noble ou non noble par CVD,
- éventuellement une autre étape de dispersion d'un autre métal noble ou non noble par CVD, et
- une troisième étape de stabilisation des dépôts catalytiques par traitement thermique.

Dans un exemple de réalisation, la première étape est une étape d'application d'un imprégnateur ou « washcoat », qui peut être composé de plusieurs oxydes mixtes de nature différente, pris parmi : Al₂O₃, CeO₂-ZrO₂, BaO₂, zéolithe, TiO₂/V₂O₅. Dans la seconde étape, le métal peut être pris parmi : Pt, Pd, Rh, Au, Ag, Cu, Ru. La structure en matériau poreux peut être une structure céramique de type nid d'abeille ou mousse céramique.

L'invention concerne également un dispositif d'infiltration d'une structure en matériau poreux par dépôt chimique en phase vapeur comprenant deux faces opposées, la première face étant exposée à un flux gazeux, et des moyens de maintien de la seconde face, au moins en partie, libre de tout contact, **caractérisé en ce que** ces moyens de maintien comprennent un support percé de canaux parallèles, et muni d'un cône de forçage.

Avantageusement, le support est un support cylindrique en inconel.

Dans une variante de réalisation, le dispositif de l'invention comprend au moins deux sous-supports superposés à répartitions d'ouvertures différentes.

Le procédé de l'invention permet d'adapter la technique CVD en forçant le flux gazeux à pénétrer la structure en matériau poreux dans toute son épaisseur. On dirige ainsi de façon privilégiée le flux gazeux vers la première face de la structure en matériau poreux et on libère au moins en partie la seconde face de cette structure de façon à « aspirer » le flux gazeux. La seconde face « ouverte » peut être adaptée : nombre de trous dans la structure, hauteur D de suspension de la structure par rapport au support, inclinaison α de la structure, etc..., en fonction de la taille des canaux et de l'épaisseur qu'on souhaite déposer,

Le procédé de l'invention permet d'obtenir des multicouches ou des hétérostructures pour des systèmes catalytiques (couche d'imprégnateur « WashCoat » + métal). Il permet de déposer des composés du type oxydes (Al₂O₃, CeO₂, YSZ, V₂O₅, BaO, TiO₂, ...) sous forme de films continus ou discontinus (poudres ou particules) sur un support (ou substrat) de type poreux. Il permet également de déposer des composés métalliques du groupe VIII (Fe, Ru, Co, Rh, Ir, Ni, Pd, Pt) et I (Cu, Ag, Au) sous forme de nanoparticules.

La géométrie particulière du support muni d'ouvertures permet une imprégnation efficace de la structure en matériau poreux de type support filtrant pour la catalyse tel qu'une mousse ou nid d'abeilles avec des porosités de 2 à 600 cpsi (canaux par pouce carré) et/ou 2 à 60 ppi (pores par pouce carré). Elle conduit à un dépôt de couche active homogène non seulement du point de vue de l'épaisseur mais également de la structure. L'imprégnation des parois filtrantes en profondeur d'un tel support filtrant favorise l'échange en volume et permet d'optimiser la surface spécifique.

La maîtrise des conditions opératoires permet, de plus, de moduler la morphologie (taille) et la concentration (dispersion) des catalyseurs et d'accéder ainsi à la synthèse de particules de taille nanométrique (< 20 nm) très finement dispersées (distance inter-particulaire < 50 nm).

Grâce au procédé de l'invention, il est également possible de déposer des systèmes catalytiques complets (« washcoat » + métal) au sein de structures en matériau poreux complexes en surface (2D) ou en volume (3D). Les catalyseurs se présentent sous la forme de films minces continus et homogènes et/ou de particules de taille nanométrique (de 1 à 100 nm de diamètre) bien dispersées en surface d'un support dense ou poreux.

Le procédé de l'invention permet enfin de :
- réaliser la synthèse des systèmes catalytiques de manière sélective sur les supports grâce à un four tubulaire réglable ;
- réaliser la synthèse de pièces de dimensions variées par changement de la platine d'infiltration ;
- réaliser la stabilisation du « washcoat » ou des couches catalytiques actives par traitement.

Les domaines d'application du procédé et du dispositif de l'invention sont par exemple la catalyse de l'air (traitement des COV, des NOx), la génération d'hydrogène par reformage d'hydrocarbures, ou de biocarburants ou le stockage d'hydrogène par adsorption.

### BRÈVE DESCRIPTION DES DESSINS

Les figures 1A, 1B et 1C illustrent trois modes de réalisation du dispositif de l'invention.
Les figures 2A et 2B illustrent un exemple de support, respectivement dans une vue de dessus et dans une vue en coupe.
La figure 3 illustre le dispositif de l'invention mettant en oeuvre le support illustré sur la figure 2.
Les figures 4A et 4B illustrent deux exemples de mesures donnant la taille des particules obtenues en fonction de la teneur en catalyseur.
Les figures 5 et 6 illustrent schématiquement des variantes de réalisation du dispositif de l'invention.

### EXPOSÉ DÉTAILLÉ DE MODES DE RÉALISATION PARTICULIERS

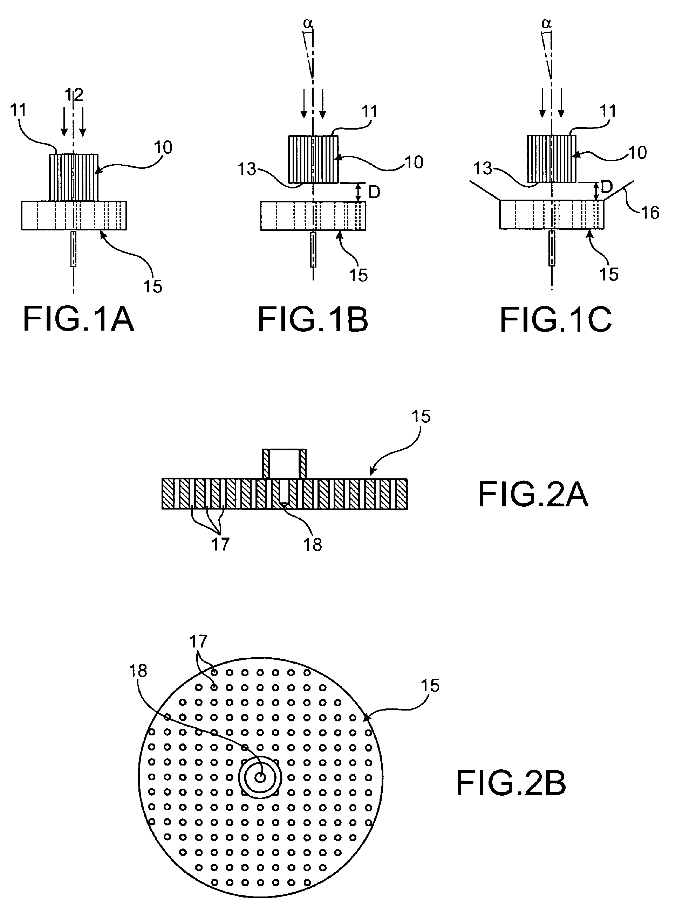

Comme illustré sur les figures 1A, 1B et 1C, le procédé d'infiltration d'une structure 10 en matériau poreux munie de deux faces opposées, par dépôt chimique en phase vapeur selon l'invention, consiste à exposer la première face 11 à un flux gazeux 12, la seconde face 13 étant au moins en partie libre de tout contact, ce qui permet de maîtriser la croissance, la densité et la taille des particules au sein de la structure 10.

Dans un premier mode de réalisation, illustré sur la figure 1A, la structure 10 est posée sur un support 15 présentant des ouvertures, par exemple des canaux 17 parallèles. Dans ce premier mode de réalisation, les films obtenus permettent une infiltration sélective de ces canaux 17.

Dans un second mode de réalisation, illustré sur la figure 1B, la structure 10 est suspendue au-dessus du support 15 à une distance D de celui-ci, cette distance D pouvant être réglable. Ce second mode de réalisation permet de réaliser un gradient de dépôt entre l'entrée (première face 11) et la sortie (seconde face 13) de la structure en matériau poreux 10.

Un troisième mode de réalisation correspond au second mode de réalisation avec la mise en oeuvre d'un cône de forçage 16 disposé au-dessus du support 15. La structure 10 est alors intégralement traversée par le flux gazeux 12, ce qui permet d'obtenir un dépôt homogène sur toute la hauteur de la structure 10.

Le procédé de l'invention comprend les étapes suivantes :
- une première étape de dépôt d'une pré-couche composée d'un ou plusieurs oxydes ou « washcoat » sous forme d'un film continu ou discontinu d'épaisseur généralement supérieure à 20, 50 nm et même 300 nm ;
- une seconde étape de dispersion de métal noble ou non noble sous forme de nanoparticules de diamètre généralement inférieur à 20 nm sur le « washcoat » préalablement déposé, avec une dispersion de l'ordre de 50 particules par µm² ;
- éventuellement une troisième étape de stabilisation des dépôts catalytiques par traitement thermique par exemple sous atmosphère contrôlée (vide ou pression partielle d'un gaz comme O₂, H₂, Ar).

Dans la première étape, la surface de réaction peut être fortement augmentée par l'application d'un « washcoat » homogène de grande surface spécifique. Ce « washcoat » peut être composé d'un ou plusieurs oxydes mixtes de nature différente (Al₂O₃, CeO₂-ZrO₂, BaO₂, zéolithe, TiO₂/V₂O₅, etc...).

Dans la seconde étape, le métal noble ou non noble est le composant principal du catalyseur déposé sur le « washcoat », qui permet notamment de diminuer les énergies d'activation des réactions. Ce composant est généralement du platine (Pt) ou du palladium (Pd) ; de plus ces matériaux présentent une bonne stabilité. D'autres métaux nobles peuvent être utilisés suivant les applications visées (Rh (rhodium), Au (or) ou non nobles (Ag, Cu, ...)). La technique de dépôt en phase vapeur permet le dépôt de couches minces à partir de précurseurs organo-métalliques ou de sels métalliques. Il est ainsi possible d'élaborer une couche active homogène (« washcoat ») composée d'oxydes mixtes ou bien de déposer de manière dense ou dispersée des métaux nobles sur des supports macroporeux (CVD) dans un même réacteur adapté au milieu réactionnel en ce qui concerne les matériaux de fabrication.

Le procédé de l'invention permet de synthétiser des systèmes catalytiques composés de couches minces continues et discontinues déposées au sein d'une structure en matériau poreux. Il permet une réelle amélioration du point de vue de l'infiltration de substrats catalytiques et de leur stabilisation (traitement thermique in situ) en vue de leur intégration.

Un tel procédé est « propre » car il utilise très peu de solvants organiques et permet de récupérer des produits purs et secs qui peuvent éventuellement être ensuite recyclés. De plus, il est peu contraignant en terme de recouvrement de géométries complexes telles que les supports utilisés dans le domaine du traitement des effluents gazeux (mousses ou nids d'abeille céramiques, ...).

Par rapport aux procédés classiques de dépôt CVD de catalyseurs le procédé de l'invention permet l'élaboration d'un imprégnateur ou « washcoat » puis la dispersion de métaux nobles ou non nobles dans un même réacteur au sein d'une structure 3D en matériau poreux. Ce procédé permet également une fabrication dans une seule enceinte de systèmes catalytiques complets trouvant des applications directes dans le domaine du traitement de l'air (par exemple traitement des COV, NOx pour les pots catalytiques), pour la génération d'hydrogène par reformage, ou pour des matériaux de stockage de l'hydrogène.

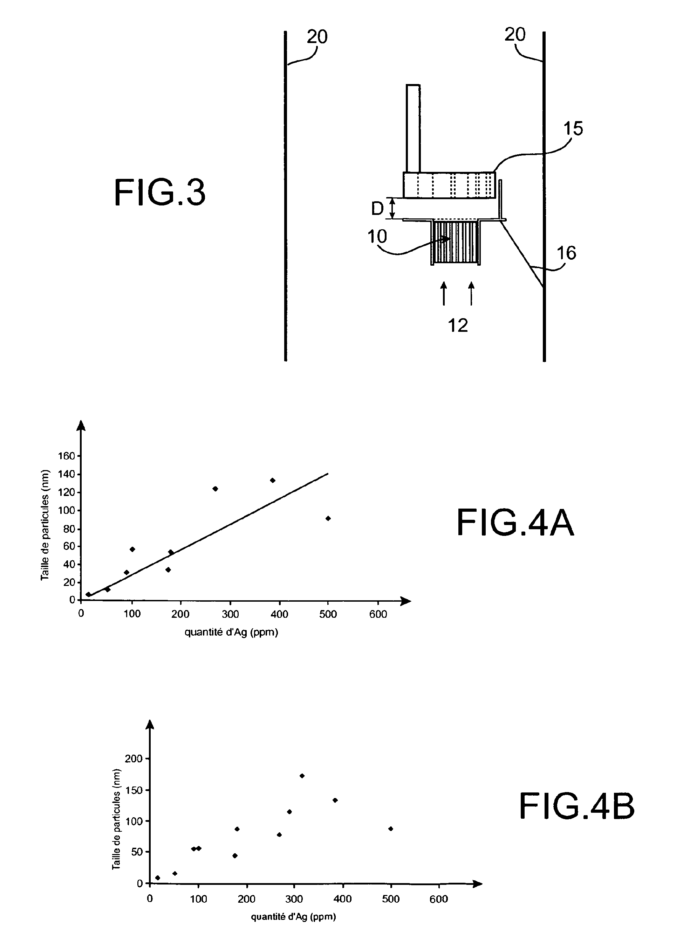

Le réacteur CVD alors utilisé peut avoir une géométrie spécifique avec une arrivée des gaz réactifs par la partie inférieure du réacteur comme décrit dans le document référencé [3], et comme illustré sur la figure 3. Les structures à revêtir se trouvent ainsi suspendues au-dessus du flux de gaz, ce qui permet d'éviter toute pollution par des particules qui dans cette configuration retombent par gravité. De plus, un four tubulaire monté sur glissière permet de régler le gradient thermique ce qui permet de déposer de façon sélective sur une ou toute la hauteur d'un support macroporeux, de chauffer de manière homogène le support ou de créer un gradient thermique.

Les figures 2A, 2B et 3 illustrent un exemple de support circulaire 15 en inconel par exemple de 80 mm de diamètre et de 10 mm de hauteur. Ce support 15 est percé d'ouvertures, par exemple des canaux cylindriques 17 de 2 mm de diamètre dont les centres sont espacés de 5 mm, et d'une ouverture 18 en forme de canal terminé par un cône en son centre. Un tel support permet, d'une part, une infiltration améliorée des structures poreuses et, d'autre part, une bonne inertie thermique. Le cône de forçage de flux 16 tel qu'illustré sur la figure 1C, permet à l'intégralité du flux gazeux 12 de traverser la structure en matériau poreux 10. La détente du gaz au sein de cette structure 10 peut être ajustée en modifiant la distance D (de 1 à 20 mm) entre le support 15 et la structure 10. La référence 20 désigne les parois du réacteur CVD.

Dans le cas d'une application, par exemple les pots catalytiques, la structure poreuse peut avoir des dimensions plus importantes (typiquement diamètre 145 mm, hauteur 100 mm). La porosité du matériau étant la même que pour les structures plus petites, la taille des ouvertures dans le support est aussi du même ordre de grandeur que celles du support des petites structures.

Dans des variantes de réalisation avantageuses, le support 15 peut comprendre deux sous-supports superposés 30 et 31, dont les répartitions des ouvertures sont différentes. L'un des sous-supports, par exemple le sous-support 31, peut être amovible et interchangeable, ce qui permet d'adapter la répartition totale du support à l'application visée. En effet, la sélection de certaines ouvertures peut être voulue soit pour empêcher le dépôt dans certains pores, soit pour déposer des types de particules différents selon les pores.

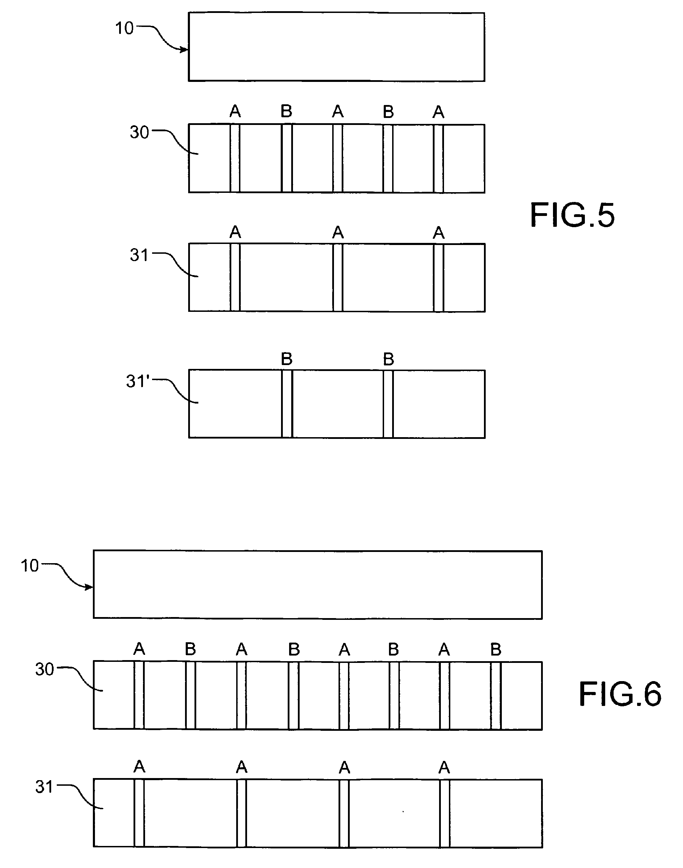

Ainsi, dans un premier mode de réalisation illustré sur la figure 5, dans une première étape les sous-supports 30 et 31 sont superposés, ce qui permet de réaliser le remplissage des pores de la structure 10, à la verticale de premiers canaux A, par un premier matériau. Dans une seconde étape, on remplace le sous-support 31 par le sous-support 31', ce qui permet de réaliser le remplissage des pores de la structure 10, à la verticale de seconds canaux B, par un second matériau. Dans un second mode de réalisation illustré sur la figure 6, dans une première étape, on réalise un dépôt avec les deux sous-supports 30 et 31, ce qui permet un remplissage des pores de la structure 10 à la verticale des premiers canaux A par un premier matériau. Dans une seconde étape, le sous-support 31 étant ôté, on réalise le remplissage des pores de la structure 10 à la verticale des premiers et seconds canaux A et B par un second matériau.

On peut également considérer un même support 15, en déplaçant la structure 10 par rapport à la répartition des ouvertures de ce support (par exemple par rotation).

Enfin, en plaçant la structure 10 à une hauteur D adaptable au-dessus du support 15 présentant des ouvertures, la répartition du dépôt dans les pores peut être facilement modulable par ajustement de cette hauteur (comme le cas où le support n'est pas percé) sans changer de support.

La structure 10 peut également être inclinable suivant un angle α (par exemple de 1° à 15°) par rapport à la normale à la surface du support 15. Une telle inclinaison de la structure 10 permet de générer des turbulences au sein des canaux 17 qui conduisent à un dépôt en gradient ou localisé (uniquement au centre de la structure 10). De tels dépôts permettent d'améliorer les performances théoriques des catalyseurs comme décrit dans le document référencé [4].

### Exemple de mode de réalisation

Dans un exemple de réalisation, la structure en matériau poreux 10 est une structure céramique de type nid d'abeille, mousse céramique, ou toute autre structure géométrique complexe.

Cette structure dense ou macroporeuse peut être en cordiérite (2Al₂O₃.2SiO₂.5MgO), en carbure de silicium (SiC), en alumine de titane (Al₂O₃.TiO₂), en alumine zircone (Al₂O₃.ZrO₂) ...

On a alors les étapes suivantes :
- dépôt d'une couche mince homogène de « washcoat » qui peut être composé d'oxydes mixtes de nature différente (Al₂O₃, CeO₂-ZrO₂, BaO₂, zéolithe, TiO₂/V₂O₅, etc...).
- dépôt chimique en phase vapeur, qui consiste à disperser des métaux nobles ou non nobles (catalyseurs) sur le « washcoat », les métaux nobles pouvant être de nature différente suivant le type de catalyse visé (Pt, Pt/Rh, Ag/Pt/Rh, Ag, Au, ...).

La taille des particules obtenues oscillent entre 3 et 200 nm, comme illustré sur les figures 4A et 4B, en fonction du taux de chargement (teneur) en Ag entre 20 et 4000 ppm.

Il est intéressant de constater que pour chaque teneur en Ag, la valeur de la taille des particules à mi-hauteur des ouvertures du support (figure 4A) est sensiblement égale à la valeur moyenne calculée sur toute la hauteur des ouvertures (figure 4B) : le dépôt est donc homogène sur toute la hauteur des ouvertures.

### Références

[1] "Promotional effect of SO2 on the selective catalytic reduction of NOx with propane/propene over Ag/γ-Al2O3" de T.N. Angelidis et N. Kruse (Applied Catalysis B : Environmental 34, 2001, pages 201-212).
[2] "Preparation of beta-coated cordierite honeycomb monoliths by in situ synthesis Utilisation as Pt support for NOx abatement in diesel exhaust" de A. Bueno-Lopez, D. Lozano-Castello, I. Such-Basanez, J.M. Garcia-Cortes, M.J. Illan-Gomez, C. Salinas-Martinez de Lecea (Applied Catalysis B : Environmental 58, 2005, pages 1-7).
[3] "Synthesis and characterisation of YBCO thin films grown by injection- MOCVD" de J.P. Sénateur, F. Felten, S. Pignard, F. Weiss, A. Abrutis, V. Bigelyte, A. Teiserskis, Z. Saltyte et B. Vengalis (Journal of Alloys and Compounds 251, 1997, pages 288-291).
[4] "Preparation of axially non-uniform Pd catalytic monoliths by chemical vapour deposition" de Vania Cominos et Asterios Gavriilidis (Applied Catalysis A : General 210 (2001), pages 381-390).

## Revendications

1. Procédé d'infiltration d'une structure en matériau poreux (10) par dépôt chimique en phase vapeur comprenant deux faces opposées, la première face (11) étant exposée à un flux gazeux (12), la seconde face (12) étant, au moins en partie, libre de tout contact, **caractérisé en ce que** l'on dispose un support (15) percé de canaux parallèles et muni d'un cône de forçage (16) en sortie de la structure en matériau poreux par rapport au flux gazeux, cette structure étant posée sur, ou suspendue au dessus de ce support.

2. Procédé selon la revendication 1, dans lequel le support (15) est un support cylindrique en inconel.

3. Procédé selon la revendication 1, dans lequel on bascule d'un angle α la structure en matériau poreux (10) par rapport à la normale du support (15), α étant compris entre 1 et 15°.

4. Procédé selon la revendication 1, qui comprend les étapes suivantes :
- une première étape de synthèse de particules ou de film d'oxydes,
- une seconde étape de dispersion d'au moins un métal noble ou non noble par CVD.

5. Procédé selon la revendication 4, dans lequel le procédé est suivi d'une autre étape de dispersion d'un autre métal noble ou non noble par CVD.

6. Procédé selon la revendication 4, comprenant une troisième étape de stabilisation des dépôts par traitement thermique.

7. Procédé selon la revendication 4, dans lequel la première étape est une étape d'application d'une couche d'imprégnateur (« washcoat »).

8. Procédé selon la revendication 7, dans lequel l'imprégnateur est composé de plusieurs oxydes mixtes de nature différente, pris parmi : Al₂O₃, CeO₂-ZrO₂, BaO₂, zéolithe, TiO₂/V₂O₅.

9. Procédé selon la revendication 4, dans lequel, dans la seconde étape, le métal est pris parmi : Pt, Pd, Rh, Au, Ag, Cu, Ru.

10. Procédé selon la revendication 1, dans lequel la structure en matériau poreux est une structure céramique de type nid d'abeille ou mousse céramique.

11. Dispositif d'infiltration d'une structure en matériau poreux (10) par dépôt chimique en phase vapeur comprenant deux faces opposées, la première face (11) étant exposée à un flux gazeux (12), et des moyens de maintien de la seconde face (12), au moins en partie, libre de tout contact, **caractérisé en ce que** ces moyens de maintien comprennent un support (15) percé de canaux parallèles, et muni d'un cône de forçage (16).

12. Dispositif selon la revendication 11, dans lequel le support (15) est un support cylindrique en inconel.

13. Dispositif selon la revendication 11, qui comprend au moins deux sous-supports (30, 31) superposés à répartitions d'ouvertures différentes.

## Claims

1. Method for the infiltration of a structure made of a porous material (10) by chemical vapour deposition comprising two opposing faces, the first face (11) being exposed to a gaseous flow (12), the second face (12) being, at least partially, free from any contact, **characterised in that** a support (15) pierced with parallel channels and provided with a forcing cone (16) is interposed between the gaseous flow and the porous material structure, said structure being laid on, or suspended above, said support.

2. Method according to claim 1, wherein the support (15) is a cylindrical support made of Inconel.

3. Method according to claim 1, wherein the porous material structure (10) is tilted by an angle α in relation to the normal of the support (15), α being between 1 and 15°.

4. Method according to claim 1, which comprises the following steps:
- a first step of synthesis of particles or film of oxides,
- a second step of dispersion of at least one noble or non-noble metal by CVD.

5. Method according to claim 4, wherein the method is followed by another step of dispersion of another noble or non-noble metal by CVD.

6. Method according to claim 4, comprising a third step of stabilisation of the depositions by heat treatment.

7. Method according to claim 4, wherein the first step is a step of application of an impregnator layer ("washcoat").

8. Method according to claim 7, wherein the impregnator is composed of several mixed oxides of different nature, selected from: Al₂O₃, CeO₂-ZrO₂, BaO₂, zeolite, TiO₂/V₂O₅.

9. Method according to claim 4, wherein, in the second step, the metal is selected from: Pt, Pd, Rh, Au, Ag, Cu, Ru.

10. Method according to claim 1, wherein the porous material structure is a ceramic structure of honeycomb or ceramic foam type.

11. Device for the infiltration of a structure made of a porous material (10) by chemical vapour deposition comprising two opposing faces, the first face (11) being exposed to a gaseous flow (12), and means for maintaining the second face (12), at least partially, free from any contact, **characterised in that** said maintaining means comprise a support (15) pierced with parallel channels, and provided with a forcing cone (16).

12. Device according to claim 11, wherein the support (15) is a cylindrical support made of Inconel.

13. Device according to claim 11, which comprises at least two superimposed sub-supports (30, 31) superimposed with different opening distributions.

## Patentansprüche

1. Verfahren zur Infiltration einer Struktur aus porösem Material (10), die zwei entgegengesetzte Seiten umfiaßt, mittels chemischer Gasphasenabscheidung, wobei die erste Seite (11) einem Gasfluß (12) ausgesetzt ist, wobei die zweite Seite (12) wenigstens teilweise frei von jeglichem Kontakt ist, **dadurch gekennzeichnet, dass** man einen Träger (15), in den parallele Kanäle gebohrt sind und der mit einem Formsenkkegel (16) ausgestattet ist, am Ausgang der Struktur aus porösem Material bezogen auf den Gasfluß anordnet, wobei diese Struktur auf diesem Träger platziert ist oder über diesem Träger aufgehängt ist.

2. Verfahren nach Anspruch 1, bei dem der Träger (15) ein zylindrischer Träger aus Inconel ist.

3. Verfahren nach Anspruch 1, bei dem man die Struktur aus porösem Material (10) bezogen auf die Normale des Trägers (15) um einen Winkel α kippt, wobei α zwischen 1 und 15° enthalten ist.

4. Verfahren nach Anspruch 1, das die folgenden Schritte umfaßt:
- einen ersten Schritt der Synthese von Partikeln oder eines Filmes aus Oxide,
- einen zweiten Schritt der Dispersion wenigstens eines Edelmetalls oder Nichtedelmefialls mittels CVD.

5. Verfahren nach Anspruch 4, bei dem auf das Verfahren ein weiterer Schritt der Dispersion eines anderen Edelmetalls oder Nichtedelmetalls mittels CVD folgt.

6. Verfahren nach Anspruch 4, umfassend einen dritten Schritt der Stabilisierung der Abscheidungen durch thermische Behandlung.

7. Verfahren nach Anspruch 4, bei dem der erste Schritt ein Schritt der Aufbringung einer Schicht aus einem Imprägniermittel ("washcoat") ist.

8. Verfahren nach Anspruch 7, bei dem das Imprägniermittel aus verschiedenen gemischten Oxiden unterschiedlicher Art zusammengesetzt ist, ausgewählt aus: Al₂O₃, CeO₂-ZrO₂, BaO₂, Zeolithe, TiO₂/V₂O₅.

9. Verfahren nach Anspruch 4, bei dem im zweiten Schritt das Metall ausgewählt ist aus: Pt, Pd, Rh, Au, Ag, Cu, Ru.

10. Verfahren nach Anspruch 1, bei dem die Struktur aus porösem Material eine keramische Struktur vom Waben- oder vom Keramikschaumtyp ist.

11. Vorrichtung zur Infiltration einer Struktur aus porösem Material (10) mittels chemischer Gasphasenabscheidung, umfassend zwei entgegengesetzte Seiten, wobei die erste Seite (11) einem Gasfluß (12) ausgesetzt ist, sowie Mittel zum Halten der zweiten Seite (12) wenigstens teilweise frei von jeglichem Kontakt, **dadurch gekennzeichnet, dass** diese Haltemittel einen Träger (15) umfassen, in den parallele Kanäle gebohrt sind und der mit einem Formsenkkegel (16) ausgestattet ist.

12. Vorrichtung nach Anspruch 11, bei dem der Träger (15) ein zylindrischer Träger aus Inconel ist.

13. Vorrichtung nach Anspruch 11, die wenigstens zwei Unterträger (30, 31) umfaßt, welche mit unterschiedlichen Verteilungen von Öffnungen überlagert sind.
